# FASCICULE DE BREVET EUROPEEN

(11) **EP 1 515 211 B1**
(45) Date de publication et mention de la délivrance du brevet: **13.10.2010**
(21) Numéro de dépôt: 04360076.6
(22) Date de dépôt: 31.08.2004
(51) Int. Cl.: G05D 3/10, H03K 17/96, E05F 15/16, B60J 1/17, H01H 13/70

(54) **Commande tactile à capteurs capacitifs pour lève-vitre ou toit-ouvrant électrique**
Kapazitiver Berührungsschalter für elektrische Fensterheber oder Schiebedach
Capacitive touch switch for electrical window regulator or open roof

(30) Priorité: 09.09.2003 FR 0310632
(43) Date de publication de la demande: 16.03.2005
(73) Titulaire: Delphi Technologies Inc., Troy, Michigan 48007 (US)
(72) Inventeur: Kayser, Hervé, 67640 Fegersheim (FR); Zann, Olivier, 67280 Urmatt (FR)
(74) Mandataire: Robert, Vincent

(56) Documents cités:
- EP-A- 0 284 057
- EP-A- 0 731 407
- EP-A- 0 932 117
- EP-A- 1 111 878
- EP-A- 1 197 835
- WO-A-00/23873
- FR-A- 2 829 522
- US-A- 4 321 479
- US-A- 5 942 733

## Description

La présente invention a trait à un dispositif de commande de la variation d'un paramètre physique, plus précisément la position d'une paroi mobile de type vitre d'ouvrant de véhicule automobile, ainsi qu'à un procédé pour la mise en oeuvre de ce dispositif.

Les vitres latérales d'un véhicule automobile sont d'ordinaire commandées à l'aide de boutons-poussoirs disposés dans des consoles généralement localisées au niveau des portières ou, au moins pour la commande centralisée, sur la console centrale située entre les sièges avant du véhicule.

Le document FR - 2 829 522 décrit un dispositif de commande de la variation d'un paramètre physique fonctionnant par glissement d'un doigt de l'utilisateur sur un pavé tactile résistif.

Le glissement entraîne la commande de la variation du paramètre physique selon un sens reflétant le sens de glissement du doigt.

Le document US-A-4 321 479 divulgue un pavé capacitif dont le fonctionnement est basé sur celui d'une molette de réglage : les déplacements d'un doigt au contact d'une surface tactile sont analysés de manière à déterminer le sens et l'amplitude du déplacement du doigt. Ce dispositif est basé sur deux registres à décalage mémorisant deux situations de contact successives du doigt sur la surface tactile.

La présente invention est également basée sur une manipulation très intuitive, au cours de laquelle la variation du paramètre est induite à petite échelle par le déplacement du doigt de l'utilisateur sur une surface prévue à cet effet. En d'autres termes, le dispositif de commande fonctionne par glissement d'un doigt sur cette surface, entraînant la commande de la variation dudit paramètre physique selon un sens qui reflète le sens du glissement du doigt sur ladite surface. Le pilotage de la variation se fait donc de manière très intuitive et immédiate.

A cet effet, le dispositif de commande de l'invention est classiquement constitué :
- d'une plaque détectrice munie d'une surface externe plane destinée à entrer en contact avec le doigt ou à être effleuré par lui ;
- de moyens électroniques de traitement de l'information en provenance de la plaque détectrice et de pilotage d'un circuit comportant des moyens de commande des variations de la position de la paroi mobile, lesdites variations reflétant l'amplitude du glissement du doigt sur la plaque détectrice.

Par rapport aux dispositifs de l'art antérieur, lorsqu'ils sont constitués de boutons poussoirs, ce système présente une grande fiabilité, car il ne comporte plus de pièces mécaniques en mouvement les unes par rapport aux autres, soumises en plus à des efforts répétés, et qui sont par conséquent des maillons faibles en terme de fiabilité.

Dans le secteur de l'automobile, les constructeurs cherchent de plus à réduire l'encombrement des organes de commandes dans l'habitacle, du fait de leur multiplication, et à optimiser les espaces disponibles. Le dispositif de l'invention, dépourvu de toute partie mécanique mobile, présente un faible encombrement puisqu'il ne comporte à titre essentiel que la plaque détectrice et les composants électroniques disposés sur un circuit imprimé. Au final, on aboutit à un produit de faible épaisseur, qui occupe un volume bien inférieur à celui que nécessitaient les commutateurs électromécaniques de l'art antérieur.

Ce nouveau concept n'est en outre pas préjudiciable à l'ergonomie du fonctionnement. L'utilisation est simple et intuitive, puisque le pilotage par exemple des vitres se fait par un mouvement du doigt qui schématise symboliquement le déplacement, dans le sens de la levée ou de la descente, de la vitre. La commande ne requiert enfin pratiquement aucune réflexion, du fait de son aspect intuitif, et le conducteur peut la mettre en oeuvre sans absorber une partie de la concentration nécessitée par la conduite du véhicule. La sécurité s'en trouve renforcée.

Selon l'invention, les capteurs qui sont utilisés dans le nouveau dispositif de commande sont des capteurs capacitifs.

La technologie capacitive permet une architecture relativement légère, insensible à la poussière, aux salissures, etc. Compte tenu de sa simplicité, cette technologie est de plus relativement peu onéreuse.

Plus précisément, le dispositif de commande de l'invention est constitué de plusieurs capteurs capacitifs reliés aux moyens électroniques précités et disposés d'une part en ligne suivant l'axe de la plaque détectrice de manière à modéliser par leur tracé la variabilité de la position de la paroi, et d'autre part à proximité de ladite surface externe en vue de détecter le contact du doigt sur ladite plaque.

Les moyens de traitement électroniques émettent au moins un signal définissant le déplacement de la paroi mobile à l'adresse de moyens d'entraînement de ladite paroi, les moyens de traitement calculant le pourcentage du parcours tracé par les capteurs sur la plaque détectrice qui est effectivement parcouru par le doigt de l'utilisateur, et commandant des moyens d'entraînement pour que la paroi mobile se déplace d'une fraction de son trajet total égale au même pourcentage ou d'une fraction égale au pourcentage calculé de la distance qui lui reste à parcourir pour arriver en butée.

Selon une configuration possible, lesdits capteurs comprennent au moins une électrode connectée à une cellule de détection de la charge électrique de l'électrode.

Les électrodes relaient l'information relative à l'existence d'un contact sur la plaque détectrice, attestée par une modification de leur charge électrique.

Elles prennent par exemple la forme de pastilles métalliques disposées dans ou sur la plaque détectrice. Chaque capteur est ensuite relié à un port d'entrée d'un microcontrôleur traitant ses signaux et constituant les moyens électroniques de traitement de l'information, dont les ports de sortie sont reliés au circuit comportant les moyens de commande des variations du paramètre, constituant les moyens d'entraînement de la paroi.

Les informations fournies par les capteurs sont donc disponibles en parallèle sur tous les ports d'entrée, fournissant un code différent selon la position du doigt sur la plaque détectrice.

Comme mentionné, dans l'invention qui s'applique à la commande d'ouvrants de véhicules, les électrodes sont plus précisément disposées en ligne suivant l'axe de la plaque détectrice. Le déplacement rectiligne du doigt sur ladite plaque, dans un sens ou dans un autre, suffit alors à entraîner le déplacement de l'ouvrant dans le sens demandé, en vue de son ouverture ou de sa fermeture.

Encore une fois, les capteurs capacitifs étant disponibles sous forme de composant CMS, le dispositif de commande à glissement selon l'invention présente une épaisseur qui n'excède pas 3 mm. Le volume global s'assimile donc à une plaquette d'allure rectangulaire, et d'épaisseur réduite.

L'invention concerne également un procédé de commande de la variation d'un paramètre physique constitué de la position d'une paroi mobile par exemple de type vitre d'ouvrants de véhicules, à l'aide d'un dispositif de commande tel que décrit auparavant, dont les moyens électroniques de traitement de signaux issus des capteurs :
- déterminent le sens du déplacement du doigt par comparaison des positions successivement parcourues ;
- émettent au moins un signal définissant le sens de la variation à l'adresse des moyens de commande des variations de position de la paroi.

Le procédé de l'invention se caractérise en ce que les moyens électroniques de traitement :
- déterminent la position initiale du doigt lorsqu'un signal en provenance d'au moins un capteur est détecté, par reconnaissance du ou des capteurs activés ;
- calculent itérativement chaque position occupée ensuite par le doigt pour mesurer l'amplitude du glissement du doigt ;
- calculent le pourcentage du parcours tracé par les capteurs sur la plaque détectrice qui est effectivement parcourue par le doigt de l'utilisateur ; et
- émettent au moins un signal définissant le déplacement de la paroi mobile à l'adresse de moyens d'entraînement de ladite paroi.

La partie centrale du traitement consiste, une fois la détection d'un contact du doigt avec la plaque détectrice effectuée, à comparer le positionnement initial avec le positionnement ultérieur, afin de déterminer le sens de déplacement du doigt, et par conséquent le sens de commande qui est par exemple requis pour l'entraînement des moyens moteurs d'une vitre.

Au moins un signal issu des moyens de traitement électroniques définit également l'amplitude de la variation du déplacement.

Selon un mode de fonctionnement, les moyens de traitement commandent les moyens d'entraînement de la paroi mobile pour qu'elle se déplace d'une fraction de son trajet total égale au pourcentage calculé.

Dans cette hypothèse de fonctionnement, le déplacement de la vitre reflète homothétiquement celui du doigt, évidemment rapporté à la totalité de la longueur de la plaque détectrice.

Selon un autre mode de fonctionnement, qui s'apparente cependant au précédent, les moyens de traitement commandent les moyens d'entraînement de la paroi mobile pour qu'elle se déplace d'une fraction égale au même pourcentage de la distance qui lui reste à parcourir pour arriver en butée.

Ce type de déplacement assure un réglage très précis de la position de la paroi mobile.

Dans les deux dernières hypothèses de fonctionnement, la vitre s'arrête lorsque le pourcentage de la course à effectuer, reflétant celui parcouru par le doigt, est atteint.

Selon une possibilité, le signal pilotant les moyens de commande cesse d'être émis par les moyens de traitement lorsque, après plusieurs itérations, le ou les mêmes capteurs sont activés, indiquant que le doigt ne se déplace plus.

L'immobilisation du doigt est alors interprétée par le système comme indiquant la volonté de l'utilisateur d'arrêter de faire varier le déplacement de la paroi mobile du type vitre d'ouvrant de véhicule.

Alternativement, le signal pilotant les moyens d'entraînement peut n'être plus émis par les moyens de traitement lorsque aucun capteur n'est plus activé, indiquant que le doigt n'est plus au contact de la plaque détectrice.

Le microcontrôleur, faisant office de moyens de traitement électronique, peut dans certaines hypothèses gérer, outre le positionnement du doigt, sa vitesse de déplacement. Ainsi, lorsque les moyens de traitement détectent un déplacement d'un doigt le long d'au moins un nombre prédéterminé de capteurs en un temps inférieur à une durée prédéterminée, il peut passer en un mode d'entraînement rapide des moyens d'entraînement de la paroi mobile, laquelle est alors entraînée vers la butée marquant la fin de son déplacement dans le sens choisi.

Cette fonction permet la fermeture/l'ouverture rapide de la vitre. A l'inverse, lorsque la vitesse détectée est inférieure au seuil prédéterminé, la vitre s'ouvre/se ferme à vitesse inférieure, et uniquement pendant le déplacement/contact du doigt sur la plaque détectrice.

L'invention va à présent être décrite plus en détail, en référence aux figures annexées, pour lesquelles :
- la figure 1 montre en perspective une portion de portière de voiture équipée d'un dispositif de commande de la variation de la position d'une vitre d'ouvrant selon l'invention, lequel dispositif est également représenté de manière agrandie ;
- la figure 2 représente un schéma électronique du système de détection ;
- la figure 3 illustre une possibilité de circuit électronique de traitement des signaux issus du système de détection, ainsi que de l'étage électronique de puissance ; et
- la figure 4 représente un organigramme général du fonctionnement de l'invention.

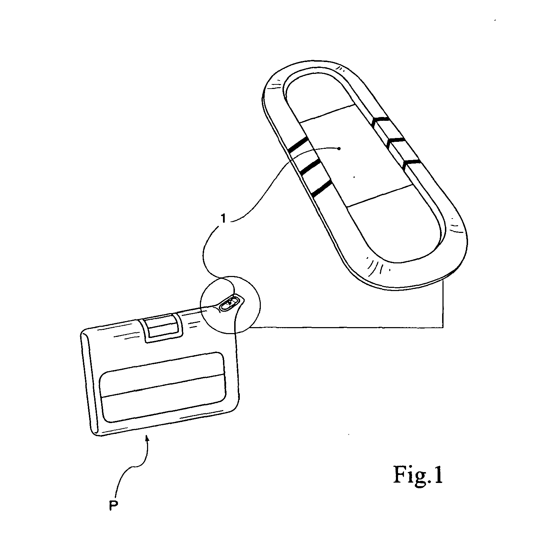

La portion de portière (P) représentée en figure 1 comporte à proximité et au niveau de la poignée d'ouverture de ladite portière (P) une surface plane agrandie en partie supérieure de cette même figure. Cette surface est réalisée avec une plaque (1) détectrice dans laquelle sont logées, en ligne, les électrodes permettant la détection du mouvement, voire de la vitesse de déplacement, du doigt de l'utilisateur lorsqu'il la parcourt.

Compte tenu de son orientation dans la portière, la manipulation de cette plaque (1) est immédiatement et intuitivement compréhensible. Ainsi, un utilisateur qui veut ouvrir, donc descendre la vitre, fera glisser son doigt vers le bas. A l'inverse, lorsque la fermeture c'est-à-dire la remontée de la vitre est envisagée, il suffira d'opérer un glissement vers le haut sur cette plaque (1). Il suffit de respecter l'analogie avec le sens de déplacement que l'on veut conférer à la vitre.

La plaque (1) comporte, selon un tracé rectiligne qui reflète le trajet de la paroi mobile que l'on veut commander, des électrodes qui permettent de détecter la position, et donc le déplacement du doigt de l'utilisateur.

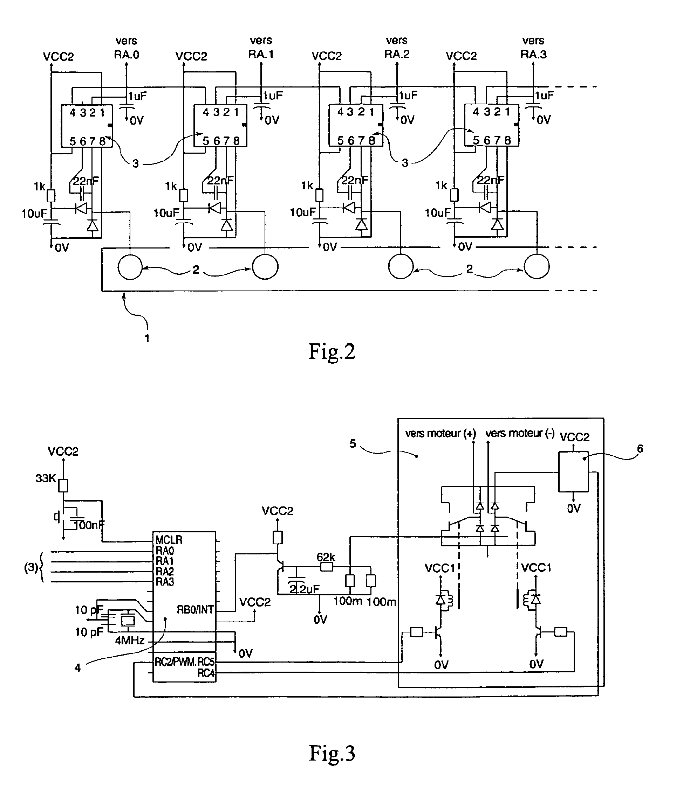

Ainsi que cela apparaît en figure 2, ces électrodes prennent par exemple la forme de pastilles (2) métalliques, distribuées le long du trajet fictif tel que reproduit dans la plaque (1). Ces électrodes (2) sont chacune reliées à une cellule (3) de détection, en l'occurrence un composant spécialement dévolu à cette fonction. Chaque cellule de détection (3) comporte une sortie qui donne l'état de la détection capacitive, et qui est connectée à un port d'entrée d'un microcontrôleur (4) apparaissant en figure 3, chargé du traitement de ces signaux. Les ports d'entrée, ici au nombre de quatre, sont respectivement référencés RA0, RA1, RA2 et RA3.

Les ports de sortie RC2/PWM, RC4 et RC5 du microcontrôleur (4) sont quant à eux connectés à un circuit de puissance (5) chargé du pilotage du moteur prévu pour entraîner la vitre. Les sorties RC4 et RC5 pilotent chacune la bobine d'un relais, lesdits relais actionnant des commutateurs contrôlant un pont d'alimentation du moteur, en vue de lui donner un sens de rotation.

La sortie RC2/PWM est une sortie impulsionnelle, pilotant un transistor de puissance MOSFET permettant l'alimentation du moteur d'une part, et la gestion de sa vitesse d'autre part. Cette vitesse de rotation est gérée par le rapport cyclique qui pilote le transistor MOSFET.

L'entrée RBO/INT est configurée comme une entrée d'interruption. Elle rend compte du positionnement de la vitre par rapport aux fins de course. Dans le cas où une fin de course est atteinte, le programme produit une interruption et une initialisation. Cette entrée est activée par un détecteur de courant : il se trouve en effet que lorsque les vitres atteignent leur fin de course ou un obstacle, il se produit un pic de courant dans le circuit de puissance. Lorsque ce pic est détecté, le moteur est stoppé grâce à l'information qui arrive sur l'entrée RBO/INT.

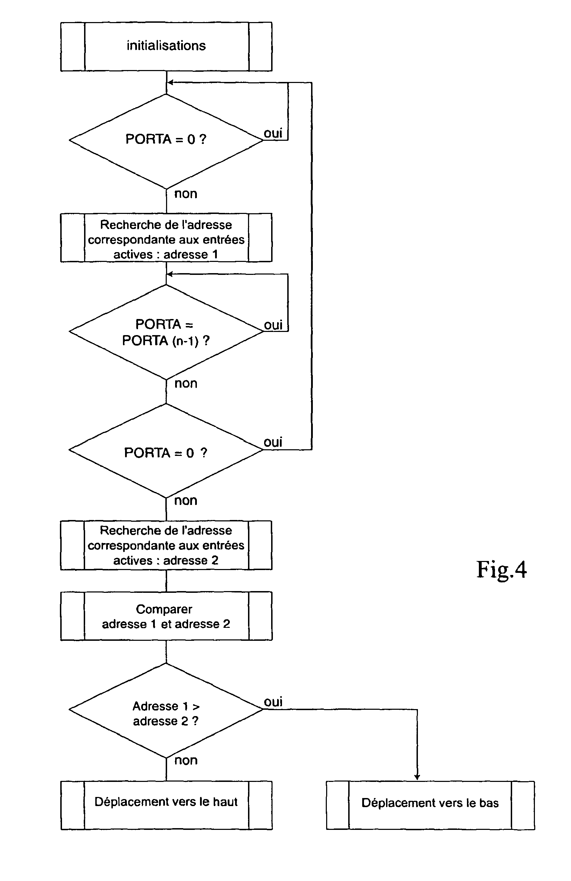

La figure 4 représente l'organigramme principal du fonctionnement. Lorsqu'un contact est détecté sur le port A, entendu comme regroupant la totalité des ports RA0 à RA3, le microcontrôleur recherche l'adresse correspondant aux entrées actives, qui constitue l'adresse 1.

Si une nouvelle détection montre une modification des codes arrivant sur le port A, il y a une nouvelle recherche de l'adresse correspondante, qui constitue l'adresse 2. S'il n'y a pas de nouvelle adresse, le programme vérifie s'il y a toujours contact, mais au même endroit, ou si le contact s'est interrompu. Aucune information n'est alors envoyée au moteur de commande de la vitre.

Lorsqu'il y a eu déplacement, les adresses 1 et 2 sont comparées, et le résultat de cette comparaison permet d'envoyer une donnée soit en sortie RC4, soit en sortie RC5, afin d'initier un déplacement vers le haut ou vers le bas.

La largeur des impulsions de commande émises en RC2/PWM dépend notamment de la vitesse et de l'amplitude du déplacement du doigt sur la plaque détectrice.

## Revendications

1. Dispositif de commande de la variation d'un paramètre physique constitué de la position d'une paroi mobile par exemple de type vitre d'ouvrant de véhicule, fonctionnant par glissement d'un doigt de l'utilisateur sur une surface entraînant la commande de la variation de ladite position selon un sens reflétant le sens du glissement du doigt, comportant une plaque (1) détectrice munie d'une surface externe plane destinée à entrer en contact avec le doigt ou à être effleuré par lui, des moyens électroniques (4) de traitement de l'information en provenance de la plaque détectrice et de pilotage d'un circuit (5) comportant des moyens de commande des variations de ladite position, lesdites variations reflétant l'amplitude du glissement du doigt sur la plaque (1) détectrice, **caractérisé en ce qu'**il est constitué de plusieurs capteurs (2, 3) capacitifs reliés auxdits moyens électroniques (4) et disposés d'une part en ligne suivant l'axe de la plaque (1) détectrice de manière à modéliser par leur tracé la variabilité de la position de la paroi, et d'autre part à proximité de ladite surface externe en vue de détecter le contact du doigt sur ladite plaque (1), et **en ce que** les moyens de traitement électroniques (4) émettent au moins un signal définissant le déplacement de la paroi mobile à l'adresse de moyens d'entraînement de ladite paroi, les moyens de traitement (4) calculant le pourcentage du parcours tracé par les capteurs (2, 3) sur la plaque (1) détectrice qui est effectivement parcouru par le doigt de l'utilisateur, et commandant les moyens d'entraînement pour que la paroi mobile se déplace d'une fraction de son trajet total égal au même pourcentage ou d'une fraction égale au pourcentage calculé de la distance qui lui reste à parcourir pour arriver en butée.

2. Dispositif de commande de la variation d'un paramètre physique selon la revendication précédente, **caractérisé en ce que** lesdits capteurs comprennent au moins une électrode (2) connectée à une cellule de détection (3) de la charge électrique de l'électrode (2).

3. Dispositif de commande de la variation d'un paramètre physique selon la revendication précédente, **caractérisé en ce que** les électrodes (2) sont des pastilles métalliques disposées dans ou sur la plaque (1) détectrice.

4. Dispositif de commande de la variation d'un paramètre physique selon l'une quelconque des revendications précédentes, **caractérisé en ce** chaque capteur (2, 3) est relié à un port d'entrée d'un microcontrôleur (4) traitant ses signaux et constituant les moyens électroniques de traitement de l'information, dont les ports de sortie sont reliés au circuit (5) comportant les moyens de commande des variations du paramètre, constituant les moyens d'entraînement de la paroi.

5. Procédé de commande de la variation d'un paramètre physique constitué de la position d'une paroi mobile par exemple de type vitre d'ouvrant de véhicule, à l'aide d'un dispositif de commande selon l'une des revendications précédentes, dont les moyens électroniques (4) de traitement de signaux issus des capteurs (2, 3) :
- déterminent le sens du déplacement du doigt par comparaison des positions successivement parcourues ;
- émettent au moins un signal définissant le sens de la variation à l'adresse des moyens de commande des variations de la position de la paroi,
**caractérisé en ce que** lesdits moyens électroniques de traitement :
- déterminent au surplus la position initiale du doigt lorsqu'un signal en provenance d'au moins un capteur (2, 3) est détecté, par reconnaissance du ou des capteurs (2, 3) activés ;
- calculent itérativement chaque position occupée ensuite par le doigt pour mesurer l'amplitude du glissement du doigt;
- calculent le pourcentage du parcours tracé par les capteurs (2, 3) sur la plaque (1) détectrice qui est effectivement parcouru par le doigt de l'utilisateur ; et
- émettent au moins un signal définissant le déplacement de la paroi mobile à l'adresse de moyens d'entraînement de ladite paroi.

6. Procédé de commande du déplacement d'une paroi mobile selon la revendication 5, **caractérisé en ce que** les moyens de traitement (4) commandent les moyens d'entraînement de la paroi mobile pour qu'elle se déplace d'une fraction de son trajet total égale au pourcentage calculé.

7. Procédé de commande du déplacement d'une paroi mobile selon la revendication 5, **caractérisé en ce que** les moyens de traitement commandent les moyens d'entraînement de la paroi mobile pour qu'elle se déplace d'une fraction égale au pourcentage calculé de la distance qui lui reste à parcourir pour arriver en butée.

8. Procédé de commande de la variation d'un paramètre physique selon l'une des revendications 5 à 7, **caractérisé en ce que** le signal pilotant les moyens de commande cesse d'être émis par les moyens de traitement (4) lorsque, après plusieurs itérations, le ou les mêmes capteurs (2, 3) sont activés, indiquant que le doigt ne se déplace plus.

9. Procédé de commande de la variation d'un paramètre physique selon selon l'une des revendications 5 à 7, **caractérisé en ce que** le signal pilotant les moyens de commande cesse d'être émis par les moyens de traitement (4) lorsque aucun capteur (2, 3) n'est plus activé, indiquant que le doigt n'est plus au contact de la plaque (1) détectrice.

10. Procédé de commande de la variation d'un paramètre physique selon l'une des revendications 5 à 9, **caractérisé en ce que** lorsque les moyens de traitement (4) détectent un déplacement du doigt le long d'au moins un nombre prédéterminé de capteurs (2, 3) en un temps inférieur à une durée prédéterminée, passe en un mode d'entraînement rapide des moyens d'entraînement de la paroi mobile, laquelle est alors entraînée vers la butée marquant la fin de son déplacement dans le sens choisi.

## Claims

1. Device for controlling the variation of a physical parameter consisting of the position of a movable wall for example of the type of a window of an opening panel of a vehicle, operating by sliding of a finger of the user on a surface driving the control of the variation of the said position in a direction reflecting the direction of sliding of the finger, including a detection plate (1) provided with a flat outer surface intended to enter into contact with the finger or to be brushed by it, electronic means (4) for processing the information emanating from the detection plate and for controlling a circuit (5) including means for controlling variations of the said position, the said variations reflecting the amplitude of the sliding of the finger on the detection plate (1), **characterised by** the fact that it is formed of a plurality of capacitive sensors (2, 3) connected to the said electronic means (4) and arranged on the one hand in a line along the axis of the detection plate (1) so as to model the variability of the position of the wall with their path, and on the other in the proximity of the said outer surface in order to detect contact of the finger with the said plate (1), and by the fact that the electronic processing means (4) emit at least a signal defining the displacement of the movable wall to the means for driving the said wall, the processing means (4) calculating the percentage of the course traced by the sensors (2, 3) on the detection plate (1) which is effectively travelled by the finger of the user and controlling the driving means so that the movable wall is displaced by a fraction of its total course equal to the same percentage or by a fraction equal to the calculated percentage of the distance which remains for it to travel to come into abutment.

2. Device for controlling the variation of a physical parameter as described in the preceding claim, **characterised by** the fact that the said sensors comprise at least one electrode (2) connected to a cell (3) for detection of the electrical charge of the electrode (2).

3. Device for controlling the variation of a physical parameter as described in the preceding claim, **characterised by** the fact that the electrodes (2) are metallic chips arranged in or on the detection plate (1).

4. Device for controlling the variation of a physical parameter as described in any one of the preceding claims, **characterised by** the fact that each sensor (2, 3) is connected to an input port of a microcontroller (4) processing its signals and forming the electronic means for processing the information, the output ports of which are connected to the circuit (5) including the means for controlling the variations of the parameter, forming the means for driving the wall.

5. Process for controlling the variation of a physical parameter consisting of the position of a movable wall for example of the type of a window of an opening panel of a vehicle, by means of a control device as described in one of the preceding claims, of which the electronic means (4) for processing signals from the sensors (2, 3):
- determine the direction of the displacement of the finger by comparison of the positions successively passed through;
- emit at least a signal defining the direction of the variation to the means for controlling the variations of the position of the wall,
**characterised by** the fact that the said electronic processing means:
- also determine the initial position of the finger when a signal is detected from at least one sensor (2, 3), by polling the activated sensor or sensors (2, 3);
- iteratively calculate each position then occupied by the finger to measure the amplitude of the sliding of the finger;
- calculate the percentage of the course traced by the sensors (2, 3) on the detection plate (1) which is effectively travelled by the finger of the user; and
- emit at least a signal defining the displacement of the movable wall to means for driving the said wall.

6. Process for controlling the displacement of a movable wall as described in claim 5, **characterised by** the fact that the processing means (4) so control the means for driving the movable wall that it is displaced by a fraction of its total course equal to the calculated percentage.

7. Process for controlling the displacement of a movable wall as described in claim 5, **characterised by** the fact that the processing means so control the means for driving the movable wall that it is displaced by a fraction equal to the calculated percentage of the distance remaining for it to travel to come into abutment.

8. Process for controlling the variation of a physical parameter as described in one of claims 5 to 7, **characterised by** the fact that the signal controlling the control means ceases to be emitted by the processing means (4) when, after a plurality of iterations, the same sensor or sensors (2, 3) are activated, indicating that the finger is no longer being displaced.

9. Process for controlling the variation of a physical parameter as described in one of claims 5 to 7, **characterised by** the fact that the signal controlling the control means ceases to be emitted by the processing means (4) when no sensor (2, 3) is any longer activated, indicating that the finger is no longer in contact with the detection plate (1).

10. Process for controlling the variation of a physical parameter as described in one of claims 5 to 9, **characterised by** the fact that when the processing means (4) detect a displacement of the finger along at least a determined number of sensors (2, 3) in a time less than a predetermined period, it enters a mode for rapid driving of the means for driving the movable wall, which is then driven towards the stop marking the end of its displacement in the selected direction.

## Patentansprüche

1. Vorrichtung zur Steuerung der Änderung eines physikalischen Parameters, der aus der Stellung einer beweglichen Wand beispielsweise vom Typ Fahrzeugtür-Fensterscheibe besteht, die durch Gleiten eines Fingers des Benutzers auf einer Fläche arbeitet, das die Steuerung der Änderung dieser Stellung in einem Sinn mit sich bringt, der den Sinn des Gleitens des Fingers wiedergibt, umfassend eine Erfassungsplatte (1), die mit einer ebenen Außenfläche versehen, die dazu bestimmt ist, mit dem Finger in Kontakt zu kommen oder von ihm berührt zu werden, elektronische Mittel (4) zur Verarbeitung der von der Erfassungsplatte kommenden Information und zur Steuerung einer Schaltung (5), die Mittel zur Steuerung der Änderungen der Stellung umfasst, wobei diese Änderungen die Amplitude des Gleitens des Fingers auf der Erfassungsplatte (1) wiedergeben, **dadurch gekennzeichnet, dass** sie aus mehreren kapazitiven Fühlern (2, 3) besteht, die mit den elektronischen Mitteln (4) verbunden sind und einerseits in der Achse der Erfassungsplatte (1) in einer Linie angeordnet sind, so dass sie durch ihre Spur die Veränderlichkeit der Stellung der Wand modellisieren, und andererseits in Nähe der Außenfläche, um den Kontakt des Fingers auf der Platte (1) zu erfassen, und dass die elektronischen Verarbeitungsmittel (4) mindestens ein die Bewegung der beweglichen Wand definierendes Signal zur Adresse der Mittel zum Antrieb der Wand senden, wobei die Verarbeitungsmittel (4) den Prozentsatz des von den Fühlern (2, 3) auf der Erfassungsplatte (1) gezeichneten Wegs berechnen, der von dem Finger des Benutzers tatsächlich durchlaufen wird, und die Antriebsmittel so steuern, dass die bewegliche Wand sich um einen Bruchteil ihres Gesamtwegs, der gleich demselben Prozentsatz ist, oder um einen Bruchteil bewegt, der gleich dem berechneten Prozentsatz der Strecke ist, die sie noch bis zur Ankunft am Anschlag zu durchlaufen hat.

2. Vorrichtung zur Steuerung der Änderung eines physikalischen Parameters nach dem vorhergehenden Anspruch, **dadurch gekennzeichnet, dass** die Fühler mindestens eine Elektrode (2) umfassen, die an eine Zelle (3) zur Erfassung der elektrischen Ladung der Elektrode (2) angeschlossen ist.

3. Vorrichtung zur Steuerung der Änderung eines physikalischen Parameters nach dem vorhergehenden Anspruch, **dadurch gekennzeichnet, dass** die Elektroden (2) metallische Plättchen sind, die in oder auf der Erfassungsplatte (1) angeordnet sind.

4. Vorrichtung zur Steuerung der Änderung eines physikalischen Parameters nach einem der vorhergehenden Ansprüche, **dadurch gekennzeichnet, dass** jeder Fühler (2, 3) mit einem Eingangsport eines Mikrosteuergeräts (4) verbunden ist, das seine Signale verarbeitet und die elektronischen Mittel zur Verarbeitung der Information bildet und dessen Ausgangsports mit der Schaltung (5) verbunden sind, die die Mittel zur Steuerung der Änderungen des Parameters umfasst, die die Mittel zum Antrieb der Wand bilden.

5. Verfahren zur Steuerung der Änderung eines physikalischen Parameters, der aus der Stellung einer beweglichen Wand beispielsweise vom Typ Fahrzeugtür-Fensterscheibe besteht, mit Hilfe einer Steuervorrichtung nach einem der vorhergehenden Ansprüche, deren elektronische Mittel (4) zur Verarbeitung von von den Fühlern (2, 3) kommenden Signalen:
- den Sinn der Bewegung des Fingers durch Vergleich der nacheinander durchlaufenen Stellungen bestimmen;
mindestens ein den Sinn der Änderung definierendes Signal zur Adresse der Mittel zur Steuerung der Änderungen der Stellung der Wand senden,
**dadurch gekennzeichnet, dass** die elektronischen Verarbeitungsmittel:
- darüber hinaus die Anfangsstellung des Fingers, wenn ein von mindestens einem Fühler (2, 3) kommendes Signal erfasst wird, durch Erkennen des oder der aktivierten Fühler (2, 3) bestimmen;
- iterativ jede dann von dem Finger eingenommene Stellung berechnen, um die Amplitude des Gleitens des Fingers zu messen;
- den Prozentsatz des von den Fühlern (2, 3) gezeichneten Wegs auf der Erfassungsplatte (1) berechnen, der von dem Finger des Benutzers tatsächlich durchlaufen wird; und
- mindestens ein die Bewegung der beweglichen Wand definierendes Signal zur Adresse von Mitteln zum Antrieb der Wand senden.

6. Verfahren zur Steuerung der Bewegung einer beweglichen Wand nach Anspruch 5, **dadurch gekennzeichnet, dass** die Verarbeitungsmittel (4) die Mittel zum Antrieb der beweglichen Wand so steuern, dass sie sich um einen Bruchteil ihres Gesamtwegs bewegt, der gleich dem berechneten Prozentsatz ist.

7. Verfahren zur Steuerung der Bewegung einer beweglichen Wand nach Anspruch 5, **dadurch gekennzeichnet, dass** die Verarbeitungsmittel die Mittel zum Antrieb der beweglichen Wand so steuern, dass sie sich um einen Bruchteil bewegt, der gleich dem berechneten Prozentsatz der Strecke ist, die sie noch bis zum Erreichen des Anschlags zu durchlaufen hat.

8. Verfahren zur Steuerung der Änderung eines physikalischen Parameters nach einem der Ansprüche 5 bis 7, **dadurch gekennzeichnet, dass** das die Steuermittel steuernde Signal aufhört, von den Verarbeitungsmitteln (4) gesendet zu werden, wenn der oder dieselben Fühler (2, 3) nach mehreren Iterationen aktiviert sind, was anzeigt, dass der Finger sich nicht mehr bewegt.

9. Verfahren zur Steuerung der Änderung eines physikalischen Parameters nach einem der Ansprüche 5 bis 7, **dadurch gekennzeichnet, dass** das die Steuermittel steuernde Signal aufhört, von den Verarbeitungsmitteln (4) gesendet zu werden, wenn kein Fühler (2, 3) mehr aktiviert wird, was anzeigt, dass der Finger nicht mehr mit der Erfassungsplatte (1) in Kontakt ist.

10. Verfahren zur Steuerung der Änderung eines physikalischen Parameters nach einem der Ansprüche 5 bis 9, **dadurch gekennzeichnet, dass**, wenn die Verarbeitungsmittel (4) eine Bewegung des Fingers längs mindestens einer vorbestimmten Anzahl von Fühlern (2, 3) in einer Zeit von weniger als einer vorbestimmten Dauer erfassen, es in einen Modus des schnellen Antriebs der Mittel zum Antrieb der beweglichen Wand übergeht, die nun zum Anschlag mitgenommen wird, der das Ende ihrer Bewegung in dem gewählten Sinn markiert.
